(19) Europäisches Patentamt / European Patent Office / Office européen des brevets

(11) **EP 4 181 628 B1**

(12) **EUROPÄISCHE PATENTSCHRIFT**

(45) Veröffentlichungstag und Bekanntmachung des Hinweises auf die Patenterteilung:
**19.02.2025 Patentblatt 2025/08**

(21) Anmeldenummer: **22216065.7**

(22) Anmeldetag: **22.11.2012**

(51) Internationale Patentklassifikation (IPC):
**H05B 41/24** (2006.01)   **H03L 7/00** (2006.01)
**H01J 37/32** (2006.01)

(52) Gemeinsame Patentklassifikation (CPC):
**H05B 41/24; H01J 37/32174; H03L 7/00;**
**H05B 47/10; Y02B 20/00**

(54) **HF-SYSTEM FÜR EINE HOCHFREQUENZLAMPE**

RF-SYSTEM FOR HIGH-FREQUENCY LAMP

RF-SYSTEME POUR LAMPE A HAUTE FRÉQUENCE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **23.11.2011 DE 102011055624**

(43) Veröffentlichungstag der Anmeldung:
**17.05.2023 Patentblatt 2023/20**

(62) Dokumentnummer(n) der früheren Anmeldung(en) nach Art. 76 EPÜ:
**12798646.1 / 2 783 553**

(73) Patentinhaber: **MACOM Technology Solutions Holdings, Inc.**
**Newport Beach, CA 92660 (US)**

(72) Erfinder:
• **HEUERMANN, Holger**
  **52076 Aachen (DE)**
• **SADEGHFAM, Arash**
  **52070 Aachen (DE)**

(74) Vertreter: **Meissner Bolte Partnerschaft mbB**
**Patentanwälte Rechtsanwälte**
**Postfach 86 06 24**
**81633 München (DE)**

(56) Entgegenhaltungen:
| | |
|---|---|
| US-A- 4 044 308 | US-A- 4 375 051 |
| US-A- 5 688 357 | US-A1- 2002 079 845 |
| US-A1- 2006 220 573 | US-A1- 2008 075 640 |
| US-A1- 2010 253 231 | US-A1- 2010 283 389 |

**Beschreibung**

Die Erfindung betrifft eine Signaleinkopplungsvorrichtung gemäß dem Oberbegriff des Anspruchs 1 sowie ein Verfahren zum Betrieb einer HF- Signaleinkopplungsvorrichtung gemäß dem Oberbegriff des Anspruchs 13.

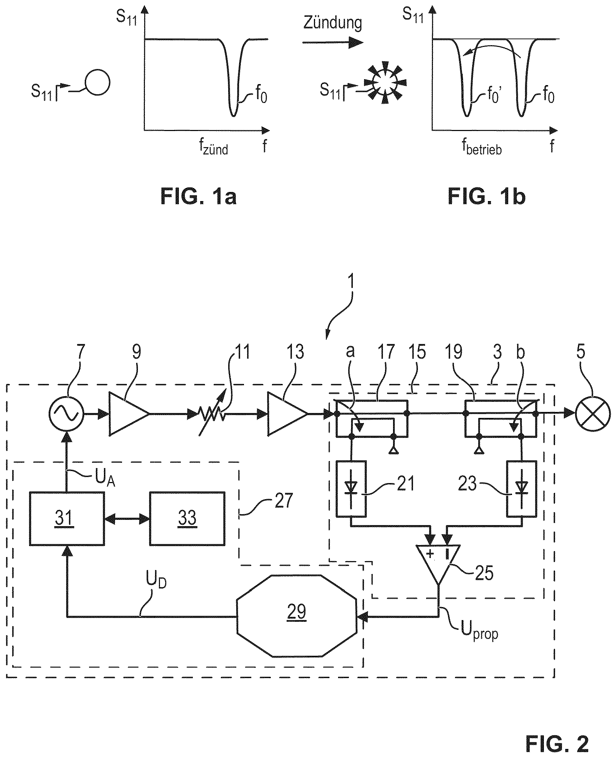

Ein HF-System der hier angesprochenen Art ist beispielsweise aus der WO 2009/068618 A2 bekannt. Es dient insbesondere zum effizienten Betrieb von Hochfrequenz-Einrichtungen wie Hochfrequenzlampen bei hohen Frequenzen, insbesondere im ISM-Band bei 2,45 GHz. Der Betrieb von HF-Einrichtungen, insbesondere HF-Lampen, HF-Zündkerzen oder dergleichen HF-Plasmaanwendungen setzt eine gute Hochfrequenzanpassung der Lampe voraus. Die Anpassung der Lampe ist frequenzabhängig und ein Maßstab dafür, welcher Anteil des durch einen Oszillator erzeugten HF-Signals zum Betrieb der Lampe von dieser aufgenommen werden kann. Je größer die Anpassung der HF-Einrichtung an die Frequenz eines zugeführten HF-Signals ist, desto geringer ist folglich der Anteil eines von der Lampe reflektierten Signals. Die Anpassung der HF-Einrichtung trägt damit wesentlich zur Gesamteffizienz des HF-Systems bei. Die Abweichung der Betriebsfrequenz von der optimalen angepassten Frequenz in einem HF-System in der Größenordnung von einigen 10 MHz können insbesondere bei hochfrequenzbetriebenen Energiesparlampen zu einer Verringerung der Effizienz von über 50% führen. Die Anpassung der HF-Einrichtung an ein zugeführtes HF-Signal ist von einigen Faktoren abhängig. Dabei handelt es sich insbesondere um Fertigungstoleranzen, das Temperaturverhalten und alterungsbedingte Änderungen der Elektronik der HF-Einrichtung. Darüber hinaus ändert sich die Lage und in der Regel auch der Betrag der Anpassung nach der Zündung der HF-Einrichtung, wie aus Fig. 1 deutlich wird. Fig. 1a zeigt eine schematische Darstellung der Betriebsfrequenz $f_0$ des der HF-Einrichtung zugeführten HF-Signals vor der Zündung und Fig. 1b zeigt dasselbe Signal nach der Zündung der HF-Einrichtung. Es wird deutlich, dass die Betriebsfrequenz $f_0$' nach der Zündung der HF-Einrichtung verlagert ist, so dass diese nicht mehr der optimalen Betriebsfrequenz der HF-Einrichtung entspricht. Die Anpassung der HF-Einrichtung ist in diesem Fall nicht mehr optimal und es kommt zu Reflektionen eines der HF-Einrichtung zugeführten HF-Signals, was wie gesagt die Effizienz der HF-Einrichtung erheblich verringern kann.

Insbesondere die amerikanische Patentanmeldung US 5 688 357 A beschreibt Betriebsmethoden zur Änderung in bei der Halbleiterverarbeitung verwendete induktiv gekoppelte HF-Plasmareaktoren des Typs, die eine gewickelte Antenne zum Koppeln von HF-Energie in die Plasmareaktorkammer verwenden.

Aus dem Stand der Technik sind Regelschaltungen bekannt, die zur dynamischen Regelung einer Anpassung einer HF-Einrichtung vorgesehen sind. Diese verwenden beispielsweise aus dem Bereich der Verstärkerentwicklung und MHz-Plasmatechnik bekannte veränderbare Kondensatoren. Dabei werden an Schrittmotoren angebundene Drehkondensatoren eingesetzt, um eine Impedanztransformation zu erzielen. Diese Lösung ermöglicht eine analoge Anpassung der HF-Einrichtung, sieht jedoch zwingend den Einsatz eines Mikrocontrollers vor, der die Regelung steuert und die einzelnen Einstellungen vornimmt. Dadurch wird zum einen die dynamische Anpassungszeit verlängert und die Schaltung wird darüber hinaus relativ aufwändig und kostenintensiv.

Darüber hinaus ist es bekannt, bei höheren Frequenzen, beispielsweise im Mobilfunkbereich, Schaltnetze vorzusehen, die durch Zu- bzw. Abschalten von unterschiedlichen induktiven und kapazitiven Elementen Anpassungswerke mit diskreten Zuständen zur dynamischen Anpassung einer Antenne ermöglichen. Durch diese Lösung können diskrete Anpasswerte für eine große Variante von Lastimpedanzen realisiert werden. Die realisierbaren diskreten Stufen und kompensierbaren Lastabweichungen sind abhängig von der Anzahl der Schaltzustände und den Elementen der Anpasswerke. Auch diese Lösung sieht zwingend den Einsatz eines Mikrocontrollers vor, was das gesamte System wiederum komplex und relativ teuer macht.

Die US 2002 / 0 79845 A1 offenbart in diesem Zusammenhang unter anderem einen Hochleistungsoszillatorkreis mit einer Resonanzpolkonfiguration mit reduzierter Komplexität, parallele HF-Leistungs-FET-Transistoren mit Soft-Gate-Schaltung, ein Schaltkreis zur kontinuierlich variablen Frequenzabstimmung, ein Richtkoppler mit sechs Anschlüssen, eine HF-Quelle mit Impedanzschaltung und eine HF-Quelle mit kontrollierten Frequenz-Last-Eigenschaften.

Aufgabe der vorliegenden Erfindung ist es daher, ein HF-System umfassend eine HF-Einrichtung und eine HF-Signaleinkopplungsvorrichtung zu schaffen, welches die Anpassung der HF-Einrichtung an eine optimale Betriebsfrequenz einfach, kostengünstig und effizient realisiert.

Ein wesentlicher Punkt der vorliegenden Erfindung liegt also darin, dass eine optimale Anpassung der HF-Einrichtung zum Zündungszeitpunkt und während des Betriebs gewährleistet wird, was durch eine Regelschaltung bewirkt wird, welche die Frequenz des Regelsignals auf die Frequenz der optimalen Anpassung der HF-Einrichtung dynamisch regelt. Eine solche Regelschaltung kann als ALL-Schaltung (Amplitude Locked Loop Schaltung) bezeichnet werden. Die HF-Signaleinkopplungs-vorrichtung ermöglicht somit eine analoge und dynamische Regelung der Frequenzlage eines HF-Signals auf die Anpassung einer HF-Einrichtung, insbesondere einer Energiesparlampe, sowohl zum Zündungszeitpunkt als auch während des Betriebs der Energiesparlampe. Im Gegensatz zu den vorbekannten Lösungen des Standes der Technik benötigt die vorliegende Erfindung vorzugsweise keinen Mikrocontroller, sondern lediglich wenige Logikgatter, die eine für die Steuerung der Schaltungselemente notwendige Logikeinheit bilden. Das gesamte HF-System wird dadurch stark vereinfacht und kann bei Bedarf auf einem einzelnen Halbleiter-IC realisiert werden.

Der wesentliche Grundgedanke der vorliegenden Erfindung liegt darin, dass ein zum Anpassungsgrad der HF-Einrichtung proportionales Spannungssignal erzeugt wird bzw. entsprechende Mittel hierzu vorgesehen sind, wobei das zum Anpassungsgrad der HF-Einrichtung proportionale Spannungssignal auf der Grundlage des durch den Oszillator erzeugten HF-Signals und eines von der HF-Einrichtung reflektierten Signals erzeugt wird. Das zum Anpassungsgrad der HF-Einrichtung proportionale Spannungssignal wird dann in einer vorzugsweise mikroprozessorlosen Einrichtung, insbesondere unter Einsatz mindestens eines Logik-Gatters, derart weiter verarbeitet, dass ein Regelsignal zur Anpassung der Ausgangsfrequenz des Oszillators innerhalb kürzester Zeit ausgegeben werden kann.

Durch die erfindungsgemäße HF-Signaleinkopplungs-vorrichtung erfolgt eine analoge Regelung der Betriebsfrequenz auf die Frequenz mit der besten Anpassung der HF-Einrichtung. Dabei wird gewährleistet, dass die Zündung des HF-Plasmas bei einer optimalen Frequenz sicher erfolgt. Außerdem wird sichergestellt, dass der Betrieb der Lampe bei einer optimalen Frequenz erfolgt. Weiterhin wird sichergestellt, dass Abweichungen zwischen der Betriebsfrequenz und der optimalen Frequenz, die beispielsweise auf Fertigungstoleranzen, Temperaturverhalten oder alterungsbedingte Änderungen der Elektronik zurückzuführen sind, bei der Zündung und während des Betriebs berücksichtigt werden. Durch den Verzicht auf einen Mikrocontroller erzielt ein bevorzugtes HF-System gemäß der vorliegenden Erfindung eine schnellere Regelung der Betriebsfrequenz, da die Regelzeit nun im Wesentlichen lediglich eine Funktion von Gatterlaufzeiten ist. Darüber hinaus wird die gesamte Schaltungsanordnung der HF-Signaleinkopplungsvorrichtung kompakter, da nur einzelne Logikgatter benötigt werden. Die Schaltungsanordnung kann auch gegebenenfalls auf einem einzelnen Halbleiter-IC realisiert werden. Mit einem Halbleiter-IC entsteht ein kompakter und günstiger Lösungsansatz für eine Massenherstellung. Ein weiterer Vorteil, den die vorliegende Erfindung bietet, ist die wesentlich weniger aufwändige Entwicklung, da die Hardware schlanker ist und keine Software benötigt wird. Dadurch, dass keine Software benötigt wird, können im Übrigen auch keine Software-Bugs auftreten, so dass das HF-System insgesamt weniger störanfällig ist.

Besonders bevorzugt wird ein HF-System, bei dem die Mittel zur Erzeugung eines zum Anpassungsgrad der HF-Einrichtung proportionalen Spannungssignals mindestens eine Auskoppeleinrichtung zur Auskopplung eines Anteils des durch den Oszillator erzeugten HF-Signals sowie mindestens eine weitere Auskoppeleinrichtung zur Auskopplung eines Anteils des von der HF-Einrichtung reflektierten Signals aufweisen. Weiterhin ist vorzugsweise eine Spannungserfassungseinrichtung zur Erfassung und Ausgabe eines Spannungssignals des ausgekoppelten Anteils des durch den Oszillator erzeugten HF-Signals und mindestens eine weitere Spannungserfassungseinrichtung zur Erfassung und Ausgabe eines Spannungssignals des ausgekoppelten Anteils des von der HF-Einrichtung reflektierten Signals vorgesehen. Zur Erzeugung des eigentlichen zum Anpassungsgrad der HF-Einrichtung proportionalen Spannungssignals ist vorzugsweise eine Einrichtung, insbesondere mindestens ein Operationsverstärker vorgesehen, welcher auf der Grundlage des Spannungssignals des ausgekoppelten Anteils des von der HF-Einrichtung reflektierten Signals sowie des Spannungssignals des ausgekoppelten Anteils des durch den Oszillator erzeugten HF-Signals, das zum Anpassungsgrad der HF-Einrichtung proportionale Spannungssignal erzeugt.

Alternativ können die Mittel zur Erzeugung eines zum Anpassungsgrad der HF-Einrichtung proportionalen Spannungssignals einen Zirkulator aufweisen, der zur Auskopplung eines Anteils des durch den Oszillator erzeugten HF-Signals sowie zur Auskopplung eines Anteils des von der HF-Einrichtung reflektierten Signals ausgebildet ist und ggf. entsprechende Spannungssignale der ausgekoppelten Anteile erfasst und ausgibt. Vorzugsweise weist der Zirkulator mindestens eine Einrichtung auf, insbesondere mindestens einen Operationsverstärker oder mindestens eine Verstärkerschaltung, welche auf der Grundlage der Spannungssignale der ausgekoppelten Anteile ein zum Spannungsgrad der HF-Einrichtung proportionales Spannungssignal erzeugt.

Bei einem weiteren bevorzugten HF-System weist die vorzugsweise mikroprozessorlose Einrichtung zur Erzeugung eines Regelsignals zur Anpassung der Ausgangsfrequenz des Oszillators eine Logikeinheit mit mindestens einem, vorzugsweise zwei Logikgattern auf, die auf der Grundlage mindestens einer, vorzugsweise drei Bedingungen ein Regelsignal zur Anpassung der Ausgangsfrequenz des Oszillators ausgibt. Weiterhin kann die Logikeinheit mit einem Schieberegister verbunden sein, wobei das Schieberegister zum Empfang eines Ausgangssignals der Logikeinheit vorgesehen ist. Darüber hinaus kann die vorzugsweise mikroprozessorlose Einrichtung auch eine Taktgebereinrichtung aufweisen zur Taktung des Ausgangssignals der Logikeinheit. Auf diese Weise kann ein künstliches digitales Signal erzeugt bzw. getaktet werden. Vorzugsweise ist die Logikeinheit über einen Schleifenfilter zur Erzeugung einer analogen Ausgangsspannung zur Regelung des Oszillators mit diesem verbunden. Die analoge Ausgangsfrequenz wird insbesondere dadurch erzeugt, dass das digitale Ausgangssignal der Logikeinheit durch den Schleifenfilter geglättet wird. Alternativ kann statt dem Schleifenfilter eine Ladungspumpenanordnung (charge-pumps) vorgesehen sein zur Erzeugung einer analogen Ausgangsspannung, zur Regelung der Frequenz des Oszillators.

Als weitere Alternative kann sowohl auf den Schleifenfilter als auch auf die Ladungspumpenanordnung verzichtet werden und stattdessen die vorzugsweise mikroprozessorlose Einrichtung und insbesondere die Logikeinheit so ausgebildet sein, dass sie zur Erzeugung einer analogen Ausgangsspannung zur Regelung der Frequenz des Oszillators ausgebildet ist. Vorzugsweise weist das HF-System auch noch eine Reset-Schaltung auf, die zum Versetzen des Oszillators in einen vordefinierten Zustand ausgebildet ist. Durch die Reset-Schaltung ist es folglich möglich, einen vordefinierten Zustand des Oszillators, insbesondere eine vordefinierte Betriebsfrequenz einzustellen.

Zur Lösung der oben beschriebenen Aufgabe wird eine Signalkopplungsvorrichtung zur Verwendung in einem HF-System nach einem der Ansprüche 1 bis 12 vorgeschlagen.

Schließlich wird zur Lösung der oben genannten Aufgabe auch noch ein Verfahren zum Betrieb einer HF- Signalkopplungsvorrichtung vorgeschlagen. Das Verfahren weist den Schritt des Erzeugens eines HF-Signals zum Betrieb der HF-Einrichtung mittels eines Oszillators auf. Es zeichnet sich dadurch aus, dass ein zum Anpassungsgrad der HF-Einrichtung proportionales Spannungssignal auf der Grundlage des durch den Oszillator erzeugten HF-Signals und eines an der HF-Einrichtung reflektierten Signals erzeugt wird. Darüber hinaus zeichnet sich das Verfahren durch Erzeugung eines Regelsignals zur Anpassung der Ausgangsfrequenz des Oszillators auf der Grundlage des zum Anpassungsgrad der HF-Einrichtung proportionalen Spannungssignals.

Bevorzugt wird ein Verfahren, bei dem eine erste Bedingung auf der Grundlage des zum Anpassungsgrad der HF-Einrichtung proportionalen Spannungssignals vor der Erzeugung eines Regelsignals zur Anpassung der Ausgangsfrequenz des Oszillators erzeugt wird. Insbesondere wird dabei die erste Bedingung durch Ableiten des zum Anpassungsgrad der HF-Einrichtung proportionalen Spannungssignals erhalten. Vorzugsweise wird noch eine zweite Bedingung auf der Grundlage des zum Anpassungsgrad der HF-Einrichtung proportionalen Spannungssignals vor der Erzeugung eines Regelsignals zur Anpassung der Ausgangsfrequenz des Oszillators erzeugt. Diese zweite Bedingung wird vorzugsweise durch Vergleichen des zum Anpassungsgrad der HF-Einrichtung proportionalen Spannungssignals mit einem vordefinierten Spannungswert erhalten. Das erfindungsgemäße Verfahren umfasst vorzugsweise noch den Schritt des Zuführens der ersten und der zweiten Bedingung und insbesondere noch einer dritten Bedingung an ein oder mehrere Logikgatter sowie das Erzeugen eines Regelsignals zur Anpassung der Ausgangsfrequenz des Oszillators auf der Grundlage einer auf dem bzw. den Logikgattern basierend Wahrheitstabelle.

Hinsichtlich der Vorteile des erfindungsgemäßen Verfahrens wird auf die oben erläuterten Vorteile der erfindungsgemäßen HF- Signalkopplungsvorrichtung verwiesen.

Die Erfindung wird im Folgenden anhand der Zeichnung näher erläutert. Es zeigen:

Fig. 1a ein schematisches Schaubild der Betriebsfrequenz vor der Zündung der HF-Einrichtung;

Fig. 1b ein schematisches Schaubild der Betriebsfrequenz nach der Zündung der HF-Einrichtung;

Fig. 2 ein schematisches Schaltbild eines Ausführungsbeispiels eines HF-Systems gemäß der Erfindung;

Fig. 3 ein schematisches Schaltbild eines Ausführungsbeispiels einer vorzugsweise mikroprozessorlosen Einrichtung zur Erzeugung eines Regelsignals zur Anpassung der Ausgangsfrequenz des Oszillators;

Fig. 4 eine schematische Darstellung eines Ausführungsbeispiels einer Logikeinheit gemäß der Erfindung;

Fig. 5 eine durch die Logikeinheit realisierte Wahrheitstabelle;

Fig. 6 eine schematische Darstellung eines Ausführungsbeispiels einer Taktgebereinrichtung;

Fig. 7 eine schematische Darstellung eines Ausführungsbeispiels eines Schleifenfilters, und

Fig. 8 eine schematische Darstellung eines Ausführungsbeispiels einer Reset-Schaltung.

Fig. 2 zeigt eine schematische Darstellung einer Ausführungsform eines HF-Systems 1 gemäß der Erfindung. Das HF-System 1 umfasst eine HF-Signaleinkopplungsvorrichtung 3 sowie eine HF-Einrichtung 5, bei der es sich um eine HF-Lampe, eine HF-Zündkerze oder dergleichen HF-Plasmaanwendung handeln kann. Im Folgenden wird die Erfindung rein beispielhaft anhand einer HF-Lampe unter Verwendung des Bezugszeichens 5 beschrieben.

Die HF-Signaleinkopplungsvorrichtung 3 dient zum Betrieb der HF-Lampe 5 und erzeugt hierzu ein HF-Signal mit einer Betriebsfrequenz für die Zündung und den Betrieb der HF-Lampe 5 mittels eines Oszillators 7. Bei der in Fig. 2 gezeigten Ausführungsform des HF-Systems 1 gemäß der Erfindung ist an den Oszillator 7 ein Verstärker 9 sowie ein Dämpfungsglied 11 angeschlossen, mittels der das Ausgangssignal des Oszillators 7 erhöht oder reduziert werden kann, bevor es über einen weiteren Verstärker 13 auf die Betriebsleistung erhöht wird. Die Verstärker 9 und 13 sowie das Dämpfungsglied 11 sind optional und können entweder weggelassen werden oder durch andere geeignete Elemente ersetzt werden. Denkbar ist auch die Anordnung in anderen Kombinationen zwischen der HF-Lampe 5 und dem Oszillator 7.

Die HF-Signaleinkopplungsvorrichtung 3 weist außerdem mit dem Bezugzeichen 15 zusammengefasste Mittel zur Erzeugung eines zum Anpassungsgrad der HF-Einrichtung proportionalen Spannungssignals auf. Gemäß der in der Fig. 2 dargestellten Ausführungsform der Erfindung umfassen diese Mittel 15 zwei Auskoppeleinrichtungen 17 und 19, wobei die Auskoppeleinrichtung 17 zur Auskopplung eines Anteils a des durch den Oszillator 7 erzeugten HF-Signals dient, während die Auskoppeleinrichtung 19 zum Auskoppeln eines Anteils b des von der HF-Lampe 5 reflektierten Signals dient. Es versteht sich, dass ein Signal b von der HF-Lampe 5 nur dann reflektiert wird, wenn die Lampe nicht optimal an die Frequenz des durch den Oszillator 7 erzeugten HF-Signals angepasst ist. Die Auskoppeleinrichtung 17 dient also zur Auskopplung einer HF-Lampe 5 hinlaufenden Leistung, während die Auskoppeleinrichtung 19 zur Auskopplung einer von der HF-Lampe 5 weglaufenden, d.h. reflektierten Leistung dient.

Die Mittel mit der Bezugziffer 15 weisen darüber hinaus eine Spannungserfassungseinrichtung 21 (Detektor) auf, welche zur Erfassung und Ausgabe eines Spannungssignals des ausgekoppelten Anteils a des durch den Oszillator 13 erzeugten HF-Signals dient. Darüber hinaus ist eine Spannungserfassungseinrichtung 23 (Detektor) vorgesehen, die zur Erfassung und Ausgabe eines Spannungssignals des ausgekoppelten Anteils des von der HF-Lampe 5 reflektierten Signals b dient. Die beiden durch die Spannungserfassungseinrichtungen 21 und 23 erzeugten Spannungssignale werden gemäß der vorliegenden Ausführungsform der Erfindung einem gemeinsamen Operationsverstärker 25 zugeführt, der basierend auf den Ausgangsspannungen der Spannungserfassungseinrichtungen 21 und 23 eine zur Lampenanpassung proportionale Spannung $U_{prop}$ erzeugt.

Alternativ zu der Ausführungsform der mit der Bezugziffer 15 gekennzeichneten Mittel zur Erzeugung eines zum Anpassungsgrad der HF-Lampe proportionalen Spannungssignals $U_{prop}$, kann statt der Auskoppeleinrichtungen 17 und 19 ein Zirkulator zum Einsatz kommen, der die beiden Signale, d.h. das HF-Signal des Oszillators 7 und das reflektierte Signal der HF-Lampe 5 aus der Verbindung zwischen der HF-Lampe 5 und dem Oszillator 7 auskoppelt. In diesem Fall kann entweder auf den Operationsverstärker 25 verzichtet werden, oder dieser kann durch eine Verstärkerschaltung ersetzt werden. Bei einer weiteren Ausführungsform der Mittel 15 zur Erzeugung eines zum Anpassungsgrad der HF-Lampe proportionalen Spannungssignals kann auch vorgesehen sein, lediglich eine Auskoppeleinrichtung 17 oder 19 vorzusehen, die jeweils zur Auskopplung sowohl des Anteils des durch den Oszillator 7 erzeugten HF-Signals sowie des von der Lampe 5 reflektierten HF-Signalanteils dienen kann.

Entscheidend ist lediglich, dass eine Einrichtung vorgesehen ist, welche aus dem HF-Signal des Oszillators 7 und des an der Lampe 5 reflektierten Signals ein zum Anpassungsgrad der HF-Einrichtung proportionales Spannungssignal erzeugt. Das heißt, das erzeugte, zum Anpassungsgrad der HF-Einrichtung proportionale Spannungssignal ist ein Maß dafür, wie viel des zur HF-Lampe 5 geführten HF-Signals des Oszillators 7 an der HF-Lampe 5 reflektiert wird und wie hoch folglich die Fehlanpassung der HF-Lampe ist.

In einem nachfolgenden Schritt wird gemäß der Erfindung die zur Lampenanpassung proportionale Spannung $U_{prop}$ einer vorzugsweise mikroprozessorlosen Einrichtung 27 zur Erzeugung eines Regelsignals zur Anpassung der Ausgangsfrequenz des Oszillators 7 zugeführt. Die vorzugsweise mikroprozessorlose Einrichtung 27 umfasst bei der in Fig. 2 gezeigten Ausführungsform einen Amplitudendiskriminator 29, einen Schleifenfilter 31 sowie eine Reset-Schaltung 33. Der Amplitudendiskriminator 29 erzeugt auf der Grundlage der zum Anpassungsgrad der HF-Lampe 5 proportionalen Spannung $U_{prop}$ eine digitale bzw. getaktete Ausgangsspannung $U_D$, die wiederum einer Filtereinrichtung, insbesondere dem Schleifenfilter 31 zugeführt wird, der das getaktete Signal $U_D$ derart glättet, dass ein im Wesentlichen analoges Ausgangssignal $U_A$ erzeugt wird, welches dem Oszillator 7 als Regelspannung zugeführt wird. Die dem Oszillator 7 zugeführte Regelspannung $U_A$ ist folglich ein Maß dafür, ob die Frequenz des Oszillators 7 erhöht, erniedrigt oder gleich bleiben soll.

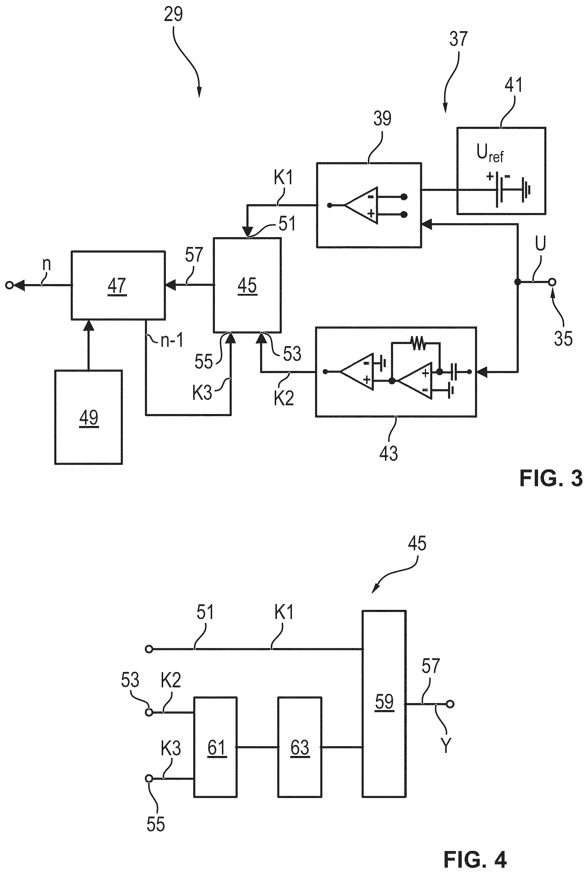

Fig. 3 zeigt eine beispielhafte Ausführungsform des in Fig. 2 dargestellten sogenannten Amplitudendiskriminators 29. Der Amplitudendiskriminator 29 weist einen Eingang 35 auf, an dem die zum Anpassungsgrad der HF-Lampe 5 proportionale Spannung $U_{prop}$ zugeführt wird. In dem Amplitudendiskriminator 29 werden bei dem vorliegenden Ausführungsbeispiel insgesamt drei Bedingungen K1, K2 und K3 erzeugt. Die erste Bedingung K1 wird auf der Grundlage des zum Anpassungsgrad der HF-Lampe 5 proportionalen Spannungssignals $U_{prop}$ erzeugt, indem es mit einem vordefinierten Spannungswert verglichen wird. Hierzu weist der Amplitudendiskriminator 29 einen Komparator 39 auf, dem einerseits das Spannungssignal $U_{prop}$ und andererseits ein fester Spannungswert zugeführt wird, der durch eine Spannungswerterzeugungseinrichtung 41 erzeugt wird. Die Spannungswerterzeugungseinrichtung 41 wird vorzugsweise durch einen Spannungsteiler realisiert. Der Komparator 39 vergleicht den aktuellen Wert der Spannung $U_{prop}$ mit dem festen Spannungswert der Spannungswerterzeugungseinrichtung 41. Das resultierende Ausgangssignal des Komparators 39 entspricht der ersten Bedingung K1.

Gleichzeitig wird in dem Amplitudendiskriminator 29 das Spannungssignal $U_{prop}$ einer Differenzierer-Einheit 43 mit integriertem invertiertem Komparator zugeführt, welche das Spannungssignal $U_{prop}$ ableitet. Das

Ausgangssignal der Differenzierer-Einheit 43 gibt folglich Aufschluss über die Tendenz der Lampenanpassung, ob diese also sinkt oder steigt, und entspricht der zweiten Bedingung K2.

Die erste Bedingung K1 und die zweite Bedingung K2 werden einer Logikeinheit 45 zugeführt. Die Logikeinheit 45 ist mit einem Schieberegister, insbesondere mit einem 2-Bit-Schieberegister 47 verbunden, welches beispielsweise durch zwei D-Flip-Flops realisiert werden kann und erhält von diesen eine dritte Bedingung K3. Das Schieberegister 47 kann, wie in der Fig. 3 dargestellt, mit einem Taktgeber 49 verbunden sein, um den analogen Vorgang innerhalb des Amplitudendiskriminators 29 künstlich zu digitalisieren bzw. zu takten.

Eine mögliche Realisierung der Logikeinheit 45 des Amplitudendiskriminators 29 ist in der schematischen Ausführungsform gemäß Fig. 4 dargestellt. Die Logikeinheit 45 umfasst drei Eingänge 51, 53 und 55, wobei über den Eingang 51 die erste Bedingung K1, über den zweiten Eingang 53 die zweite Bedingung K2 und über den dritten Eingang 55 die dritte Bedingung K3 der Logikeinheit 45 zugeführt wird. Die Logikeinheit 45 umfasst ferner einen mit dem in Fig. 3 dargestellten Schieberegister 47 verbundenen Ausgang 57.

In der beispielhaften Ausführungsform gemäß Fig. 4 umfasst die Logikeinheit 45 zwei Logikgatter 59 und 61 sowie einen Inverter 63. Bei dem Logikgatter 61 handelt es sich beispielhaft um ein XOR-Gatter, während es sich bei dem Logikgatter 49 um ein AND-Gatter handelt. Im Inverter 63 wird das zugeführte Signal des XOR-Gatters 61 invertiert. Wenn am Ausgang 57 der Logikeinheit 45 das Ausgangssignal Y steht, gilt für die in Fig. 4 gezeigte Anordnung Folgendes:

$$Y = K1 \cdot \overline{(K2 \oplus K3)}$$

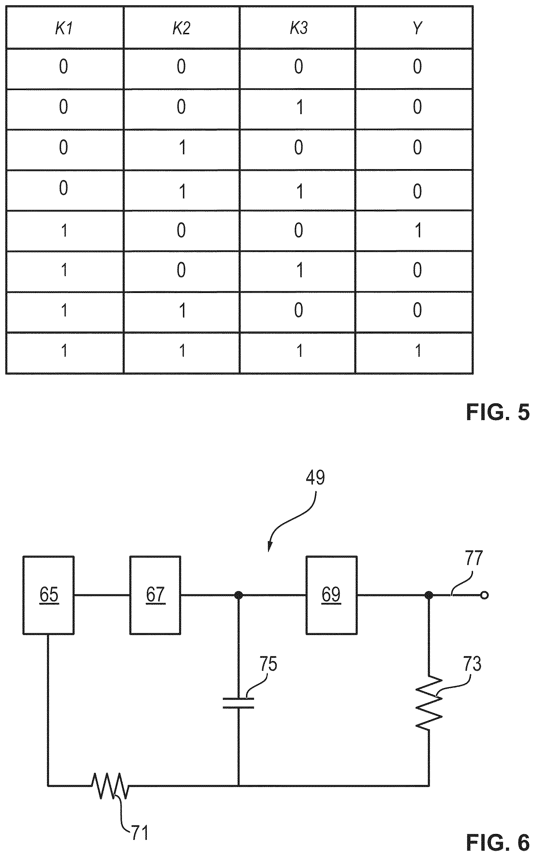

Die Logikeinheit 45, welche die oben genannte Beziehung aufweist, kann der in Fig. 5 gezeigten Wahrheitstabelle zugeordnet werden. Aus der Wahrheitstabelle gemäß Fig. 5 ergibt sich, dass bei dieser Ausführungsform die Ausgangsfrequenz des Oszillators 7 nur dann erhöht wird (Y=1), wenn die zur Lampenanpassung proportionale Spannung $U_{prop}$ vom Operationsverstärker 25 einen durch die Spannungswerterzeugungseinrichtung 41 festgelegten Wert überschreitet und gleichzeitig

- die durch die Differenzierer-Einheit 43 mit integriertem invertierendem Komparator erzeugte Bedingung K2 vorliegt (K2="1"), während das n-1 Bit aus dem Schieberegister 47 einer "0" entspricht

- oder die durch die Differenzierer-Einheit 43 mit integriertem invertiertem Komparator erzeugte Bedingung K2 nicht vorliegt (K2="0"), während das N-1 Bit aus dem Schieberegister 47 einer "1" entspricht.

Die Taktgebereinrichtung 49 ist von Vorteil, weil damit Fehlentscheidungen aufgrund eines Einschwingverhaltens der einzelnen Logikgatter vermieden werden können. Eine mögliche Realisierung der Taktgebereinrichtung 49 ist in der Fig. 6 dargestellt. Rein beispielhaft umfasst die Taktgebereinrichtung 49 dort drei Inverter 65, 67 und 69, zwei Widerstände 71 und 73 sowie einen Kondensator 75, um ein Signal am Ausgangsanschluss 77 mit einer festen Frequenz f zu realisieren. Für einen Widerstandswert R für die Widerstände 71 und 73 sowie einen Kapazitätswert C für den Kondensator 75 ergibt sich die folgende Frequenz:

$$f = 0{,}558/(RC).$$

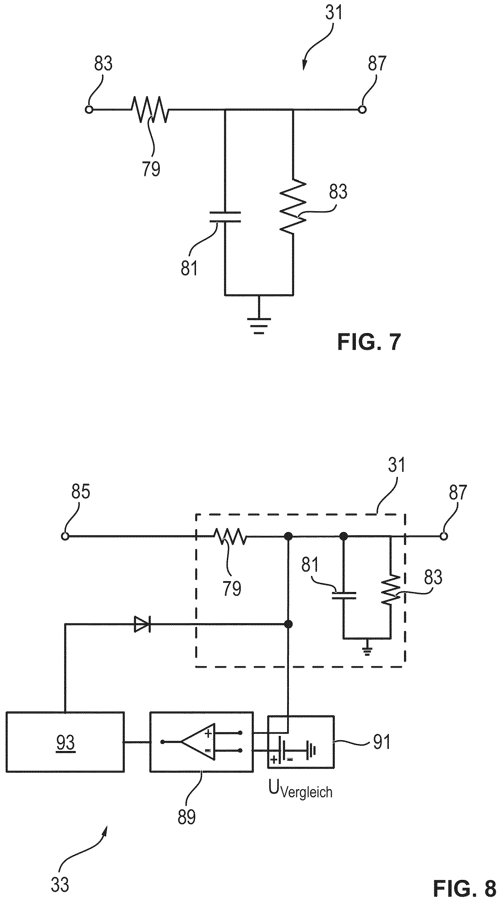

In Fig. 7 ist eine beispielhafte Ausführungsform des in Fig. 2 dargestellten Schleifenfilters 31 erkennbar, der eine getaktete Ausgangsspannung $U_D$ von dem Amplitudendiskriminator 29 erhält. Der Schleifenfilter 31 erzeugt aus den über das Schieberegister 47 laufenden digitalen Regelsignalen der Logikeinheit 45 eine analoge Spannung zur Regelung der Ausgangsfrequenz des Oszillators 7. In der Ausführungsform gemäß Fig. 7 umfasst der Schleifenfilter 31 einen Serienwiderstand 79 und mindestens einen Shunt-Kondensator 81 sowie mindestens einen Shunt-Widerstand 83, die sich zwischen den am Schieberegister 47 angeschlossenen Eingangsanschluss 85 und dem am Oszillator 7 angeschlossenen Ausgangsanschluss 87 des Schleifenfilters 31 befinden.

Zur Erhöhung der Ausgangsfrequenz des Oszillators 7 wird der Ausgang 57 der Logikeinheit 45 auf "1" gesetzt. Dieses Signal lädt den Shunt-Kondensator 81 im Schleifenfilter 31 über den Serienwiderstand 79 mit einer Zeitkonstante $\tau_{Lade}$, die dem Produkt des Widerstandswertes des Serienwiderstands 79 und der Kapazität des Shunt-Kondensators 81 entspricht, auf. Der Wert "0" am Ausgang 57 der Logikeinheit 45 führt dazu, dass die Ladung am Shunt-Kondensator 81 über die Parallelschaltung des Shunt-Widerstands 83 und des Widerstands 79 entladen wird. Die korrespondierende Zeitkonstante $\tau_{Entlade}$, entspricht dem Produkt der Kapazität des Shunt-Kondensators 81 und des resultierenden Widerstands der Parallelschaltung der zwei Widerstände 79 und 83.

Fig. 8 zeigt eine mögliche Ausführungsform der in Fig. 2 gezeigten Reset-Schaltung 33. Bei dieser Ausführungsform umfasst die Reset-Schaltung 33 einen Komparator 89, um die Spannung am Shunt-Kondensator 81 im Schleifenfilter 31 mit einer Referenzspannung $U_{Vergleich}$ zu vergleichen, wobei die Referenzspannung $U_{vergleich}$ beispielsweise durch einen externen Spannungsteiler 91 erzeugbar ist. Hierdurch kann die untere Grenzfrequenz der Regelung festgelegt werden. Wenn die Spannung am Shunt-Kondensator 81 im Schleifenfilter 31 den Spannungswert $U_{Vergleich}$ unterschreitet, wird über einen monostabilen Schalter 93 eine Spannung erzeugt, die den Shunt-Kondensator 81 im Schleifenfilter 31 auflädt. Hierdurch kann die Ausgangsfrequenz des Oszillators 7 auf eine obere Grenzfrequenz der Regelung festgelegt werden. Die Reset-Schaltung 33 und der daraus resultierende Reset-Vorgang können sowohl beim Einschalten als auch während des Betriebs der HF-Lampe 5 bei Bedarf aktiviert werden.

Zusammenfassend lässt sich festhalten, dass es sich bei dem in Fig. 2 gezeigten HF-System 1 lediglich um ein Ausführungsbeispiel handelt, welches in Bezug auf einige Elemente abänderbar ist. Insbesondere können die Auskoppeleinrichtungen durch einen Zirkulator ersetzt werden. Bei den Spannungserfassungseinrichtungen 21 und 23 kann es sich um beliebig ausgebildete geeignete Detektoren handeln. Ferner besteht die Möglichkeit, die in Fig. 8 gezeigte Reset-Schaltung 33 bzw. deren Funktion in die Logikeinheit 45 zu integrieren. Andererseits besteht die Möglichkeit, die Reset-Schaltung 33 durch Gatter, insbesondere durch Komparatoren und/oder einfache Sample-And-Hold-Schaltungen zu ersetzen.

Der Schleifenfilter 31 gemäß Fig. 7 kann im Übrigen durch Charge-Pumps, also Ladungspumpenschaltungen nach dem Vorbild einer Phase-Locked-Loop-Schaltung (PLL) ersetzt werden. Dabei kann die Schaltung so ausgebildet sein, dass eine optimale Betriebsfrequenz "gehalten" werden kann. In diesem Fall ist die Schaltung etwas komplexer und größer und erfordert eine neue Logikeinheit sowie negative Spannungen. Denkbar ist auch die Integration des Schleifenfilters 31 bzw. zumindest seine Funktion in die Logikeinheit 45. Eine analoge Ausgangsspannung wird dann unmittelbar in der Logikeinheit 45 erzeugt, sodass der Einsatz eines Taktgebers überflüssig ist. Denkbar ist auch die Erweiterung der Logikeinheit 45. Insbesondere können weitere Bedingungen berücksichtigt werden, die zusätzliche Funktionen ohne die Verwendung eines Mikroprozessors realisieren können. Hierzu sind dann evtl. zusätzliche Logik-Gatter notwendig. Im Übrigen kann auch das Schieberegister 47 geändert und insbesondere ergänzt werden, beispielsweise durch den Einsatz von astabilen Flip-Flops. Insbesondere können zusätzliche Elemente vorgesehen sein, welche den Taktgeber bzw. die Taktgebereinrichtung 49 überflüssig machen.

Auch die Verwendung von Verstärkern 9 und 12 sowie des Dämpfungsglieds 11 ist optional. Denkbar ist beispielsweise auch die Verwendung eines Verstärkers mit variabler Verstärkung zur exakteren Leistungseinstellung. Ebenso kann das Dämpfungsglied variabel ausgeführt sein oder ein entsprechendes zusätzliches variables Dämpfungsglied vorgesehen sein. Insbesondere ist auch die Reihenfolge der Verstärkung und der Dämpfung optional.

Insgesamt realisiert die vorliegende Erfindung ein HF-System und insbesondere eine vorteilhafte HF-Signaleinkopplungsvorrichtung zur Verwendung in einem HF-System zum möglichst verlustfreien Einkoppeln eines HF-Signals in eine HF-Einrichtung, insbesondere in eine HF-Lampe. Die HF-Signaleinkopplungs-vorrichtung ist vorzugsweise mikroprozessorlos ausgebildet und verwendet vielmehr Logik-Gatter, die einen Mikroprozessor überflüssig machen. Das HF-System realisiert auf diese Weise eine schnelle analoge Regelung der Ausgangsfrequenz einer HF-Signaleinkopplungsvorrichtung z.B. für Energiesparlampen. Die erfindungsgemäße HF-Signalkopplungsvorrichtung ermöglicht eine Zündung und einen effizienten Betrieb einer HF-Lampe bei derjenigen Betriebsfrequenz, welche die beste Anpassung an die HF-Lampe aufweist. Die vorteilhafte analoge Regelung kann weiterhin Frequenzverschiebungen kompensieren, die durch die Fertigungstoleranzen, das betriebsbedingte Temperaturverhalten oder alterungsbedingte Änderungen der der Elektronik hervorgerufen werden. Die implementierte Logikeinheit besteht aus einzelnen Logik-Gattern und ermöglicht folglich eine vorteilhafte Integration der Schaltung in einen einzigen Halbleiter-IC. Sie schafft folglich die Voraussetzungen für eine kostengünstige Realisierung der HF-Signaleinkopplungsvorrichtung und damit des gesamten HF-Systems in Massenherstellung.

**Patentansprüche**

1. Hochfrequenz-Signaleinkopplungsvorrichtung (3) zum Betrieb einer Hochfrequenz-Einrichtung (5) aufweisend:

> einen Oszillator (7) eingerichtet zur Erzeugung eines Hochfrequenz-Signals, das der Hochfrequenz-Einrichtung (5) zuführbar ist;
> Mittel (15) eingerichtet zur Erzeugung eines zu einem Anpassungsgrad der Hochfrequenz-Einrichtung (5) proportionalen Spannungssignals ($U_{prop}$) zu dem durch den Oszillator (7) erzeugten Hochfrequenz-Signal auf der Grundlage des durch den Oszillator (7) erzeugten Hochfrequenz-Signals und eines von der Hochfrequenz-Einrichtung reflektierten Signals; und
> eine Einrichtung (27) eingerichtet zur Erzeugung eines Regelsignals ($U_A$) zur Anpassung einer Ausgangsfrequenz des durch den Oszillator (7) erzeugten Hochfrequenz-Signals auf der Grundlage des Spannungssignals ($U_{prop}$), wobei die Einrichtung (27) einen Amplitudendiskriminator (29) und eine Schleifenfiltereinrichtung (31) aufweist, **dadurch gekennzeichnet, dass** der Amplitudendiskriminator (29) auf Grundlage des Spannungssignals ($U_{prop}$) eine digitale Ausgangsspannung ($U_D$) erzeugt, die der Schleifenfiltereinrichtung (31) zugeführt wird, der die digitale Ausgangsspannung ($U_D$) derart glättet, dass ein im Wesentlichen analoges Ausgangssignal mit einer Ausgangsspannung ($U_A$) erzeugt wird, welches dem Oszillator (7) als Regelspannung zugeführt wird.

2. Hochfrequenz-Signaleinkopplungsvorrichtung (3) nach Anspruch 1,

   wobei der Amplitudendiskriminator (29) einen Komparator (39), eine Spannungswerterzeugungseinrichtung (41), eine Differenzierer-Einheit (43) und eine Logikeinheit (45) aufweist, wobei die Logikeinheit über den Schleifenfilter (31) zur Erzeugung der analogen Ausgangsspannung ($U_A$) zur Regelung des Oszillators (7) mit diesem verbunden ist, und wobei die Spannungswerterzeugungseinrichtung (41) einen festen Spannungswert erzeugt; und der Komparator (39) das zu dem Anpassungsgrad der Hochfrequenz-Einrichtung (5) proportionale Spannungssignal ($U_{prop}$) und den festen Spannungswert vergleicht und eine erste Bedingung (K1) erzeugt.

3. Hochfrequenz-Signaleinkopplungsvorrichtung (3) nach Anspruch 2, wobei:

   die Differenzierer-Einheit (43) auf der Grundlage des zu dem Anpassungsgrad der Hochfrequenz-Einrichtung (5) proportionalen Spannungssignals ($U_{prop}$) eine zweite Bedingung (K2) erzeugt; und die Logikeinheit (45) einen Ausgang (57) auf der Grundlage der ersten Bedingung (K1) und der zweiten Bedingung (K2) erzeugt.

4. Hochfrequenz-Signaleinkopplungsvorrichtung (3) nach Anspruch 3, wobei:

   der Amplitudendiskriminator (29) eine Ausgangsspannung ($U_D$) für die Schleifenfiltereinrichtung (31) auf der Grundlage des Ausgangs (57) von der Logikeinheit (45) erzeugt; und die Schleifenfiltereinrichtung (31) dazu ausgebildet ist, die Ausgangsspannung ($U_D$) zu glätten, um die analoge Ausgangsspannung ($U_A$) für den Oszillator (7) als Regelsignal zur Anpassung der Ausgangsfrequenz bereitzustellen.

5. Hochfrequenz-Signaleinkopplungsvorrichtung (3) nach Anspruch 4, wobei der Amplitudendiskriminator (29) ferner ein Schieberegister (47) zum Empfangen des Ausgangs (57) von der Logikeinheit (45) aufweist.

6. Hochfrequenz-Signaleinkopplungsvorrichtung (3) nach Anspruch 5, wobei der Amplitudendiskriminator (29) ferner eine Taktgebereinrichtung (49) zur Taktung des Ausgangs (57) von der Logikeinheit (45) in das Schieberegister (47) aufweist.

7. Hochfrequenz-Signaleinkopplungsvorrichtung (3) nach Anspruch 5, wobei die Schleifenfiltereinrichtung (31) auf der Grundlage des Ausgangs (57) von der Logikeinheit (45) das Regelsignal ($U_A$) zur Anpassung einer Ausgangsfrequenz des durch den Oszillator (7) erzeugten Hochfrequenz-Signals erzeugt.

8. Hochfrequenz-Signaleinkopplungsvorrichtung (3) nach Anspruch 7, wobei die Schleifenfiltereinrichtung (31) eine Phasenregelkreisschaltung (PPL-Schaltung) zur Steuerung der Ausgangsfrequenz des durch den Oszillator (7) erzeugten Hochfrequenz-Signals aufweist.

9. Hochfrequenz-Signaleinkopplungsvorrichtung (3) nach einem der Ansprüche 1-8, wobei die Mittel (15) zur Erzeugung des zu dem Anpassungsgrad der Hochfrequenz-Einrichtung (5) proportionalen Spannungssignals ($U_{prop}$) zumindest eine Auskoppeleinrichtung (17, 19) zur Auskopplung eines Anteils des durch den Oszillator (7) erzeugten Hochfrequenz-Signals sowie zur Auskopplung eines Anteils des von der Hochfrequenz-Einrichtung (5) reflektierten Signals aufweisen.

10. Hochfrequenz-Signaleinkopplungsvorrichtung (3) nach einem der Ansprüche 1-8, wobei die Mittel (15) zur Erzeugung des zu dem Anpassungsgrad der Hochfrequenz-Einrichtung (5) proportionalen Spannungssignals ($U_{prop}$) einen Zirkulator aufweisen, der dazu ausgebildet ist, einen Anteil des durch den Oszillator (7) erzeugten Hochfrequenz-Signals sowie einen Anteil des von der Hochfrequenz-Einrichtung (5) reflektierten Signals auszukoppeln.

11. Hochfrequenz-Signaleinkopplungsvorrichtung (3) nach einem der Ansprüche 1-8, ferner aufweisend eine Reset-Schaltung (33), um den Oszillator (7) in einen vordefinierten Zustand zu versetzen.

12. Hochfrequenz-Signaleinkopplungsvorrichtung (3) nach einem der Ansprüche 1-9, wobei die Hochfrequenz-Einrichtung (5) eines von einer Hochfrequenz-Lampe, einer Hochfrequenz-Zündkerze oder einer Hochfrequenz-Plasmavorrichtung aufweist.

13. Verfahren zum Betreiben einer Hochfrequenz-Signaleinkopplungsvorrichtung (3) nach Anspruch 1, aufweisend:

   Erzeugen eines festen Spannungswerts mittels einer Spannungswerterzeugungseinrichtung (41) des Amplitudendiskriminators (29); Erzeugen einer ersten Bedingung (K1) durch Zuführen des zu dem Anpassungsgrad der Hochfrequenz-Einrichtung (5) proportionalen Spannungssignals ($U_{prop}$) und des festen Spannungswerts zu einem Komparator (39) des Amplitudendiskriminators (29) und durch Vergleichen des zu einem Anpassungsgrad der Hochfrequenz-Einrichtung (5) proportionalen Spannungssignals ($U_{prop}$) und des festen Spannungswerts in dem Komparator (39);
Erzeugen einer zweiten Bedingung (K2) in dem Amplitudendiskriminator (29) auf der Grundlage des zu dem Anpassungsgrad der Hochfrequenz-Einrichtung (5) proportionalen Spannungssignals ($U_{prop}$);
Zuführen der ersten Bedingung (K1) und der zweiten Bedingung (K2) zu einer Logikeinheit (45) des Amplitudendiskriminators (29); und Erzeugen einer Ausgangsspannung ($U_D$) auf der Grundlage eines Ausgangs (57) der Logikeinheit (45).

**14.** Verfahren zum Betreiben der Hochfrequenz-Signaleinkopplungsvorrichtung (3) nach Anspruch 13, wobei das Erzeugen der zweiten Bedingung (K2) ein Ableiten des zu dem Anpassungsgrad der Hochfrequenz-Einrichtung (5) proportionalen Spannungssignals ($U_{prop}$) umfasst.

**Claims**

**1.** High-frequency signal injection device (3), adapted to operate a high-frequency device (5) comprising:

- an oscillator (7) for generating a high-frequency signal which is supplied to the high-frequency device (5) for its operation
- means (15) adapted to generate a voltage signal ($U_{prop}$) proportional to the degree of adaptation of the high-frequency device (5) on the basis of the high-frequency signal generated by the oscillator (7) and supplied to the high-frequency device and a signal reflected from the high-frequency device; and
- a device (27) for generating a regulating signal ($U_A$) for adjusting the output frequency of the oscillator (7) based on the voltage signal ($U_{p-rop}$) wherein the device (27) comprises an amplitude discriminator (29) and a filter device (31),

**characterized in that** the amplitude discriminator (29) creates a digital output voltage ($U_D$), based on the voltage signal ($U_{prop}$), that is supplied to the filter device (31), which smoothes the digital output voltage ($U_D$) such that a, in principle analogue, output signal with a output voltage ($U_A$) is created, which is supplied to the oscillator (7) as regulation voltage.

**2.** High-frequency signal injection device (3) according to claim 1, wherein the amplitude discriminator (29) comprises a comparator (39) a voltage value generating device (41), a differentiating unit (43) and a logic unit (45), wherein the logic unit (45) is connected to the oscillator (7) over the filter device (31) for the creation of the analogue output voltage $U_D$ for the regulation of the oscillator (7), and wherein the voltage value generating device (41) creates a fixed voltage value; and
the comparator (39) compares the voltage signal ($U_{prop}$), proportional to the degree of adaptation of the high-frequency device (5), and the fixed voltage and creates a first condition (K1).

**3.** High-frequency signal injection device (3) according to claim 2, wherein the differentiating unit (43) creates a second condition (K2), based on the voltage signal ($U_{prop}$), proportional to the degree of adaptation of the high-frequency device (5), and the logic unit (45) creates an output (57), based on the first condition (K1) and the second condition(K2).

**4.** High-frequency signal injection device (3) according to claim 3, wherein the amplitude discriminator (29) creates an output voltage ($U_D$) for the filter device (31) based on the output (57) of the logic unit (45); and
the filter device (31) is configured to smooth the output voltage ($U_D$), to provide the analogue output voltage ($U_A$) for the oscillator (7) as a regulating signal for the adjustment of the output frequency.

**5.** High-frequency signal injection device (3) according to claim 4, wherein the amplitude discriminator (29) further comprises a shift register (47) for receiving the output (57) from the logic unit (45).

**6.** High-frequency signal injection device (3) according to claim 5, wherein the amplitude discriminator (29) further comprises a clock device (49) for clocking the output (57) from the logic unit (45) into the shift register (47).

**7.** High-frequency signal injection device (3) according to claim 5, wherein the filter device (31) generates, based on the output (57) from the logic unit (45), the control signal ($U_A$) for adjusting an output frequency of the high-frequency signal generated by the oscillator (7).

**8.** High-frequency signal injection device (3) according to claim 7, wherein the filter device (31) comprises a phase-locked loop circuit (PPL circuit) for controlling the output frequency of the high-frequency signal generated by the oscillator (7).

**9.** High-frequency signal injection device (3) according to one of the claims 1 to 8, wherein the means (15) for generating the voltage signal ($U_{prop}$) proportional to the degree of adaptation of the high-frequency device (5) comprise at least one decoupling device (17, 19) for decoupling a portion of the high-frequency signal generated by the oscillator (7) and for decoupling a portion of the signal reflected by the high-frequency device (5)

10. High-frequency signal injection device (3) according to one of the claims 1 to 8, wherein the means (15) for generating the voltage signal ($U_{prop}$) proportional to the degree of adaptation of the high-frequency device (5) comprise a circulator adapted to decouple a portion of the high-frequency signal generated by the oscillator (7) and a portion of the signal reflected by the high-frequency device (5)

11. High-frequency signal injection device (3) according to one of the claims 1 to 8, further comprising a reset-circuit (33), adapted to transfer the oscillator (7) into a predefined state.

12. High-frequency signal injection device (3) according to one of the claims 1 to 9, wherein the high-frequency device (5) comprises one of a high-frequency lamp, a high-frequency spark plug or a high-frequency plasma device.

13. Method for operating a high frequency signal injection device (3) according to claim 1, comprising:

- generating a fixed voltage value by means of a voltage value generating device (41) of the amplitude discriminator (29);
- generating a first condition (K1) by supplying the voltage signal ($U_{prop}$) proportional to the degree of adaptation of the high-frequency device (5) and the fixed voltage value to a comparator (39) of the amplitude discriminator (29), and comparing the voltage signal ($U_{prop}$) proportional to the degree of adaptation of the high-frequency device (5) and the fixed voltage value in the comparator (39);
- creating a second condition (K2) in the amplitude discriminator (29), based on the voltage signal ($U_{prop}$) proportional to the degree of adaptation of the high-frequency device (5);
- supplying the first (K1) and second (K2) conditions to a logic unit (45) of the amplitude discriminator (29); and creating a output voltage ($U_D$), based on the output (57) of the logic unit (45).

14. Method for operating a high frequency signal injection device (3) according to claim 13, wherein generating the second condition (K2) comprises deriving the voltage signal ($U_{prop}$) proportional to the matching degree of the high-frequency device (5).

**Revendications**

1. Dispositif d'injection de signal à haute fréquence (3) pour le fonctionnement d'une installation à haute fréquence (5) comportant :

un oscillateur (7) agencé pour produire un signal à haute fréquence qui peut être transmis à l'installation à haute fréquence (5) ;
des moyens (15) agencés pour produire un signal de tension ($U_{prop}$) proportionnel à un degré d'adaptation de l'installation à haute fréquence (5) au signal à haute fréquence généré par l'oscillateur (7) sur la base du signal à haute fréquence généré par l'oscillateur (7) et d'un signal réfléchi par l'installation à haute fréquence et
une installation (27) agencée pour produire un signal de régulation ($U_A$) pour adapter une fréquence de sortie du signal à haute fréquence généré par l'oscillateur (7) sur la base du signal de tension ($U_{prop}$), l'installation (27) comportant un discriminateur d'amplitude (29) et une installation de filtre à boucle (31) ;

**caractérisé en ce que** le discriminateur d'amplitude (29) génère, sur la base du signal de tension ($U_{prop}$), une tension de sortie numérique ($U_D$) qui est amenée à l'installation de filtre à boucle (31) qui lisse la tension de sortie numérique ($U_D$) de façon à produire un signal de sortie sensiblement analogique ayant une tension de sortie ($U_A$), qui est amené à l'oscillateur (7) comme tension de régulation.

2. Dispositif d'injection de signal à haute fréquence (3) selon la revendication 1, dans lequel le discriminateur d'amplitude (29) comporte un comparateur (39), une installation de génération de valeurs de tension (41), une unité de différenciation (43) et une unité logique (45), dans lequel l'unité logique est connectée par l'intermédiaire du filtre à boucle (31) à l'oscillateur (7) afin de produire la tension de sortie analogique ($U_D$) pour la régulation de celui-ci (7) et

dans lequel l'installation de génération de valeurs de tension (41) génère une valeur de tension fixe et
dans lequel le comparateur (39) génère le signal de tension ($U_{prop}$) proportionnel au degré d'adaptation de l'installation à haute fréquence (5) et compare la valeur de tension fixe et génère une première condition (K1).

3. Dispositif d'injection de signal à haute fréquence (3) selon la revendication 2, dans lequel :

l'unité de différenciation (43) génère une deuxième condition (K2) sur la base du signal de

tension ($U_{prop}$) proportionnel au degré d'adaptation de l'installation à haute fréquence (5) et l'unité logique (45) génère une sortie (57) sur la base de la première condition (K1) et de la deuxième condition (K2).

4. Dispositif d'injection de signal à haute fréquence (3) selon la revendication 3, dans lequel :

le discriminateur d'amplitude (29) génère une tension de sortie ($U_D$) pour l'installation de filtre à boucle (31) sur la base de la sortie (57) de l'unité logique (45) et
l'installation de filtre à boucle (31) est conçue pour lisser la tension de sortie ($U_D$) afin de fournir la tension de sortie analogique ($U_A$) pour l'oscillateur (7) comme signal de régulation pour l'adaptation de la fréquence de sortie.

5. Dispositif d'injection de signal à haute fréquence (3) selon la revendication 4, dans lequel le discriminateur d'amplitude (29) comprend en outre un registre à décalage (47) pour la réception de la sortie (57) de l'unité logique (45).

6. Dispositif d'injection de signal à haute fréquence (3) selon la revendication 5, dans lequel le discriminateur d'amplitude (29) comporte en outre un dispositif d'horloge (49) pour cadencer la sortie (57) de l'unité logique (45) dans le registre à décalage (47).

7. Dispositif d'injection de signal à haute fréquence (3) selon la revendication 5, dans lequel l'installation de filtre à boucle (31) génère, sur la base de la sortie (57) de l'unité logique (45), le signal de régulation ($U_A$) pour l'adaptation d'une fréquence de sortie du signal à haute fréquence généré par l'oscillateur (7).

8. Dispositif d'injection de signal à haute fréquence (3) selon la revendication 7, dans lequel l'installation de filtre à boucle (31) comporte un circuit de boucle à verrouillage de phase (circuit PPL) pour contrôler la fréquence de sortie du signal à haute fréquence généré par l'oscillateur (7).

9. Dispositif d'injection de signal à haute fréquence (3) selon l'une des revendications 1 à 8, dans lequel les moyens (15) pour la génération du signal de tension ($U_{prop}$) proportionnel au degré d'adaptation de l'installation à haute fréquence (5) comportent au moins une installation de découplage (17, 19) pour découpler une partie du signal à haute fréquence généré par l'oscillateur (7) et pour découpler une partie du signal réfléchi par l'installation à haute fréquence (5).

10. Dispositif d'injection de signal à haute fréquence (3) selon l'une des revendications 1 à 8, dans lequel les moyens (15) pour la génération du signal de tension

($U_{prop}$) proportionnel au degré d'adaptation de l'installation à haute fréquence (5) comportent un circulateur qui est conçu pour découpler une partie du signal à haute fréquence généré par l'oscillateur (7) et une partie du signal réfléchi par l'installation à haute fréquence (5).

11. Dispositif d'injection de signal à haute fréquence (3) selon l'une des revendications 1 à 8, comportant en outre un circuit de réinitialisation (33) destiné à amener l'oscillateur (7) dans un état prédéfini.

12. Dispositif d'injection de signal à haute fréquence (3) selon l'une des revendications 1 à 9, dans lequel l'installation à haute fréquence (5) comporte soit une lampe à haute fréquence, soit une bougie d'allumage à haute fréquence, soit un dispositif à plasma à haute fréquence.

13. Procédé pour faire fonctionner un dispositif d'injection de signal à haute fréquence (3) selon la revendication 1, comprenant :

la génération d'une valeur de tension fixe au moyen d'une installation de génération de valeurs de tension (41) du discriminateur d'amplitude (29) ;
la génération d'une première condition (K1) par la transmission du signal de tension ($U_{prop}$) proportionnel au degré d'adaptation de l'installation à haute fréquence (5) et de la valeur de tension fixe à un comparateur (39) du discriminateur d'amplitude (29) et par la comparaison du signal de tension ($U_{prop}$) proportionnel au degré d'adaptation de l'installation à haute fréquence (5) et de la valeur de tension fixe dans le comparateur (39) ;
la génération d'une deuxième condition (K2) dans le discriminateur d'amplitude (29) sur la base du signal de tension ($U_{prop}$) proportionnel au degré d'adaptation de l'installation à haute fréquence (5) ;
la transmission de la première condition (K1) et de la deuxième condition (K2) à une unité logique (45) du discriminateur d'amplitude (29) et la génération d'une tension de sortie numérique ($U_D$) sur la base d'une sortie (57) de l'unité logique (45).

14. Procédé pour faire fonctionner le dispositif d'injection de signal à haute fréquence (3) selon la revendication 13, dans lequel la génération de la deuxième condition (K2) inclut une dérivation du signal de tension ($U_{prop}$) proportionnel au degré d'adaptation de l'installation à haute fréquence (5).

**FIG. 1a**

**FIG. 1b**

**FIG. 2**

FIG. 3

FIG. 4

| K1 | K2 | K3 | Y |
|----|----|----|---|
| 0 | 0 | 0 | 0 |
| 0 | 0 | 1 | 0 |
| 0 | 1 | 0 | 0 |
| 0 | 1 | 1 | 0 |
| 1 | 0 | 0 | 1 |
| 1 | 0 | 1 | 0 |
| 1 | 1 | 0 | 0 |
| 1 | 1 | 1 | 1 |

**FIG. 5**

**FIG. 6**

FIG. 7

FIG. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2009068618 A2
- US 5688357 A

- US 2002079845 A1